# EUROPÄISCHE PATENTSCHRIFT

(11) **EP 2 649 649 B1**
(45) Veröffentlichungstag und Bekanntmachung des Hinweises auf die Patenterteilung: **05.06.2019**
(21) Anmeldenummer: 11775937.3
(22) Anmeldetag: 20.10.2011
(51) Int. Cl.: H01L 29/861, H02M 7/06, H01L 29/78

(54) **GENERATORVORRICHTUNG ZUR SPANNUNGSVERSORGUNG EINES KRAFTFAHRZEUGS**
GENERATOR DEVICE FOR SUPPLYING VOLTAGE TO A MOTOR VEHICLE
DISPOSITIF GÉNÉRATEUR POUR ALIMENTER UN VÉHICULE À MOTEUR EN TENSION

(30) Priorität: 09.12.2010 DE 102010062677
(43) Veröffentlichungstag der Anmeldung: 16.10.2013
(73) Patentinhaber: Robert Bosch GmbH, 70442 Stuttgart (DE); Infineon Technologies AG, 85579 Neubiberg (DE)
(72) Erfinder: Bonart, Dietrich, 93077 Bad Abbach (DE); Ahlers, Dirk, 71247 München (DE); Alfred, Goerlach, 72127 Kusterdingen (DE); Richard, Spitz, 72766 Reutlingen (DE); Carolin, Tolksdorf, 72070 Tuebingen (DE)
(86) Internationale Anmeldenummer: PCT/EP2011/068298
(87) Internationale Veröffentlichungsnummer: WO 2012/076231

(56) Entgegenhaltungen:
- EP-A2- 0 807 979
- WO-A2-2005/048344
- DE-A1- 10 042 526
- DE-A1-102004 056 663
- DE-B4- 19 549 202
- US-A1- 2003 222 290
- VLADIMIR RODOV ET AL: "Super Barrier Rectifierâ A New Generation of Power Diode", IEEE TRANSACTIONS ON INDUSTRY APPLICATIONS, IEEE SERVICE CENTER, PISCATAWAY, NJ, US, Bd. 44, Nr. 1, 1. Januar 2008 (2008-01-01) , Seiten 234-237, XP011203330, ISSN: 0093-9994

## Beschreibung

Die Erfindung betrifft eine Generatorvorrichtung zur Spannungsversorgung eines Kraftfahrzeugs.

### Stand der Technik

Bei Kfz-Drehstrom- oder Wechselstromgeneratoren (Lichtmaschinen) werden zur Gleichrichtung Wechselstrombrücken (Gleichrichter) verwendet. Als gleichrichtende Elemente werden meist Halbleiterdioden mit einem pn-Übergang aus Silizium eingesetzt. Beispielsweise werden bei einem Drehstromgenerator 6 Halbleiterdioden zu einer B6-Brücke zusammengeschaltet. Gelegentlich werden auch Dioden parallelgeschaltet, beispielsweise werden anstelle von 6 Dioden 12 Dioden verwendet. Bei Wechselstromgeneratoren mit anderer Phasenzahl werden entsprechend angepasste Diodenbrücken eingesetzt. Die Dioden sind für den Betrieb bei hohen Strömen mit Stromdichten bis über 500 A/cm² und bei hohen Temperaturen mit einer maximalen Sperrschichttemperatur Tj von etwa 225 °C ausgelegt. Typischerweise beträgt der Spannungsabfall in Flussrichtung, die Flussspannung UF, bei den verwendeten hohen Strömen ca. 1 Volt. Bei einem Betrieb in Sperrrichtung fließt im Allgemeinen nur ein sehr kleiner Sperrstrom IR bis zu einer Durchbruchsspannung UZ. Ab dieser Spannung steigt der Sperrstrom sehr stark an. Ein weiterer Spannungsanstieg wird deshalb verhindert. Meist finden in diesem Zusammenhang Zenerdioden (Z-Dioden) mit Sperrspannungen -je nach Bordnetzspannung des Kraftfahrzeugs - von ca. 20 - 40 Volt Verwendung. Z-Dioden können im Durchbruch, kurzzeitig sogar mit sehr hohen Strömen, belastet werden. Sie werden deshalb zur Begrenzung der überschießenden Generatorspannung bei Lastwechseln (Loaddump) eingesetzt. Solche Dioden sind üblicherweise in robusten Einpressdiodengehäusen verpackt, wie es beispielsweise in der DE 195 49 202 B4 beschrieben ist.

Ein Nachteil einer derartigen Vorrichtung besteht darin, dass die Flussspannung der pn-Dioden zu Durchlassverlusten und damit zu einer Wirkungsgradverschlechterung des Generators führt. Da bei einer Stromabgabe des Generators im Mittel immer zwei Dioden in Reihe geschaltet sind, betragen die mittleren Durchlassverluste bei einem 100 A-Generator ca. 200 W. Die damit verbundene Aufheizung von Dioden und Gleichrichter muss durch aufwendige Kühlmaßnahmen verringert werden, beispielsweise durch eine Verwendung von Kühlkörpern oder Lüftern.

Zu einer Reduktion der Durchlassverluste wird in DE 100 42 526 A1 vorgeschlagen, Schottkydioden an Stelle von pn-Dioden einzusetzen.

Zu einer Reduktion der Durchlassverluste wird in DE 10 2004 056 663 A1 vorgeschlagen, sogenannte Hocheffizienzdioden (HED) an Stelle von pn-Dioden einzusetzen. Als Hocheffizienz-Dioden (HED) werden Schottky-Dioden bezeichnet, die im Gegensatz zu herkömmlichen Schottky-Dioden keinen durch die Sperrspannung verursachten Barrier-Lowering Effekt (BL) aufweisen und deshalb niedrige Sperrströme haben. Hocheffizienz-Schottky-Dioden (HED) bestehen aus einer monolithisch auf einem Halbleiterchip integrierten Kombination einer herkömmlichen Schottky-Diode (SBD) mit anderen Elementen wie Feldplatten, pn-Übergängen oder unterschiedlichen Barrierenmetallen. Sie sind häufig in Trenchtechnik ausgeführt.

Mit Hocheffizienz-Schottky-Dioden (HED) können wesentlich niedrigere Flussspannungen UF realisiert werden, die im Bereich von 0,5 V bis 0,6 V liegen. Durch die geringen Durchlassverluste der Dioden erhöhen sich der Wirkungsgrad und die Abgabeleistung des jeweiligen Generators. Da Schottky-Dioden als Majoritätsträgerbauelemente sehr schnell schalten, verbessert sich zudem die Rundfunkentstörung des Generators in bestimmten Frequenzbereichen um bis zu 10 dB.

In Folge der niedrigeren Sperrverlustleistungen kann zudem der Aufwand für die Kühlung der Dioden im Vergleich zu einer Verwendung von pn-Dioden reduziert werden.

Eine Herstellung von Hocheffizienz-Schottky-Dioden (HEDs) ist jedoch aufwendig und technisch sehr anspruchsvoll. Neben den sehr feinen Grabenstrukturen mit Mesaweiten im Bereich unterhalb von 500 nm, die in das Silizium geätzt werden müssen, stellt insbesondere eine kostengünstige Herstellung von geeigneten und stabilen Schottky-Kontakten eine Herausforderung dar. Als Schottky-Kontakte finden bevorzugt Nickelsilicide oder andere geeignete Silicide Verwendung. In modernen Halbleiterwerken, in denen Leistungs-MOSFETs produziert werden, stehen diese Silicidprozesse meist nicht zur Verfügung.

### Offenbarung der Erfindung

Bei der vorliegenden Erfindung wird vorgeschlagen, in Gleichrichtern für Kraftfahrzeug-Generatoren speziell hergestellte n-Kanal MOSFETs einzusetzen, bei denen Gate, Bodygebiet und Sourcegebiet fest elektrisch miteinander verbunden sind und bei denen das Draingebiet als Kathode dient. Mit diesen speziellen, auch als Pseudo-Schottky-Dioden (PSD) bezeichneten Gleichrichterelementen können ähnlich wie bei HEDs niedrige Flussspannungen erzielt werden, die kleiner sind als die Flussspannung einer pn-Diode. Ein erfindungsgemäßes Gleichrichterelement weist eine Durchlassspannung auf, die kleiner ist als 0,7 V, wenn es von einem Strom mit 500 A/cm² durchflossen wird. Vorzugsweise liegt diese Durchlassspannung zwischen 0,5 V und 0,7 V. Derartige Gleichrichterelemente enthalten keine Schottky-Kontakte und benötigen deshalb auch keine speziellen Silicidprozesse. Sie können mit leicht modifizierten Standardprozessen für MOSFETs sowohl in Planar- als auch in Trenchtechnologie hergestellt werden. Als Majoritätsträgerbauelemente schalten sie wiederum sehr schnell.

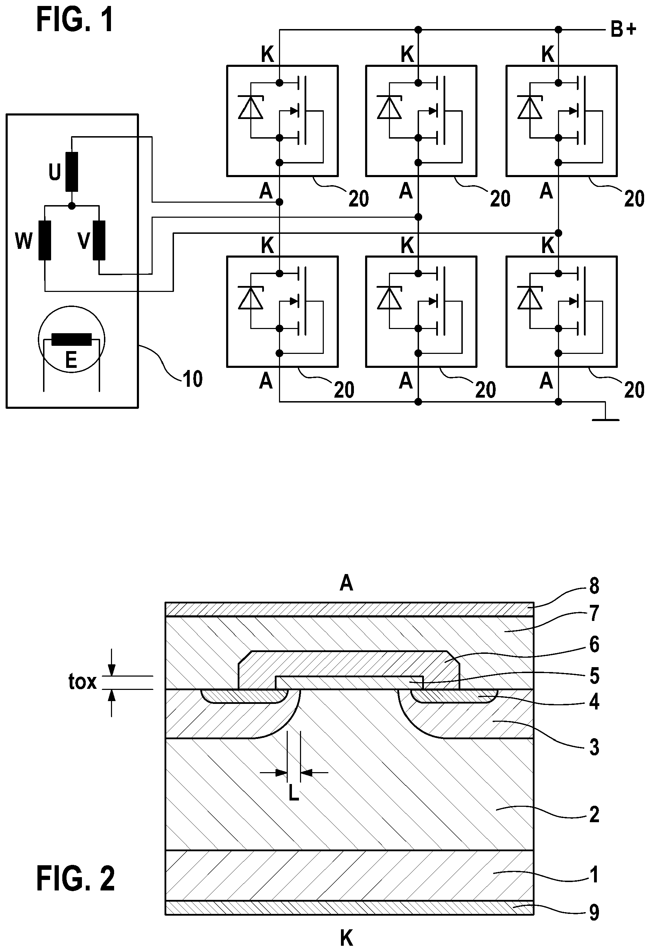

Ein Beispiel einer Generatorvorrichtung gemäß der Erfindung ist in der Fig. 1 dargestellt. Dabei bezeichnet das Bezugszeichen 10 einen in Sternschaltung betriebenen Drehstromgenerator mit den Phasen bzw. Wicklungen U, V und W und der rotierbaren Erregerwicklung E. Als Generator kann beispielsweise ein im Kraftfahrzeug üblicher Klauenpolgenerator Verwendung finden. Natürlich sind auch eine Verwendung anderer Generatoren und eine Verwendung von Generatoren mit mehr als drei Phasen möglich. Auch eine andere elektrische Verschaltung innerhalb des Generators, wie beispielsweise eine Dreiecksverschaltung, ist möglich. Die Bezugszeichen 20 bezeichnen jeweils als gleichrichtendes Bauelement eine mittels eines selbstsperrenden n-Kanal MOSFETs realisierte Pseudo-Schottky-Diode. Die selbstsperrenden n-Kanal MOSFETs 20 sind dabei so geschaltet, dass Gate, Bodygebiet und Sourcegebiet fest elektrisch miteinander verbunden sind und dass das Draingebiet als Kathode dient. Diese Verschaltung ist erfindungsgemäß monolithisch im als Pseudo-Schottky fungierenden MOSFET realisiert. Damit erhält man eine zweipolige Anordnung mit einem in der Fig. 1 eingezeichneten Anodenanschluss A und einem Kathodenanschluss K.

Liegt am Kathodenanschluss K eine positive Spannung gegenüber der Anode A an, sperrt der MOSFET, da sich sein Gate auf Sourcepotential befindet. Abgesehen von einem geringen Sperrstrom ist der Stromfluss unterbunden. In dieser Konfiguration kann der MOSFET sogar als Z-Diode verwendet werden. Damit können Überspannungen im Fehlerfall, beispielsweise bei einem Spannungsanstieg bei plötzlichem Lastabfall - im Load-Dump - begrenzt werden. Steigt die Spannung über die Durchbruchsspannung UZ der Bodydiode an, bricht die Diode durch (Avalanche- bzw. Lawinendurchbruch) und verhindert so einen weiteren Spannungsanstieg.

Wird die Spannung umgepolt, wird der Transistor im 3. Quadranten betrieben. Nach Überwindung einer Schwellspannung fließt Strom, da die integrierte Diode, die sogenannte Body-Diode, in Flussrichtung gepolt ist. Es fällt die Flussspannung UF an der Diode ab. Im Gegensatz zu einer Anordnung, bei der das Gate mit dem Drainanschluss des MOSFETs verschaltet ist, ist das Gate nun elektrisch mit dem Sourcekontakt verbunden. In diesem Fall ist die Durchlassspannung UON etwas kleiner als die Flussspannung UF. Bei handelsüblichen MOSFETs ist der Unterschied zwischen diesen beiden Spannungen allerdings sehr gering. Bei einem 60 V Leistungs-MOSFET mit einer Schwellspannung UTH von ca. 1,8 V liegt der Unterschied - gemessen im mA-Bereich - im Bereich von 20 mV. Bei Pseudo-Schottky-Dioden müssen deshalb noch weitere bauteilspezifische Eigenschaften der MOSFETs in geeigneter Weise gegenüber üblichen Transistoren verändert sein.

Der prinzipielle Aufbau einer Pseudo-Schottky-Diode (PSD) stimmt weitgehend mit dem Aufbau eines üblichen Leistungs-MOSFETs überein, wie er beispielsweise im Lehrbuch von J. Lutz, Halbleiter-Leistungsbauelemente, Springer Verlag 2006, beschrieben ist. Im Gegensatz zu einem üblichen MOSFET wird aber der Gateanschluss nicht gesondert herausgeführt, sondern direkt mit dem Sourcegebiet verbunden. Allerdings müssen noch weitere Änderungen am als PSD dienenden MOSFET erfolgen, damit eine niedrige Durchlassspannung UON auftritt.

### Dies wird nachstehend erläutert:

Eine Funktionsweise bei Betrieb im 3. Quadranten des MOSFETs, der Durchlassrichtung der PSD, kann man auch als Betrieb eines MOSFETs im 1. Quadranten bei vertauschten Source- und Drainanschlüssen S und D betrachten. Dann wird aus dem Sourcegebiet S der Drainanschluss D' und aus dem Draingebiet D der Sourceanschluss S'. Mit dieser Umbenennung wird aus dem Betrieb im 3. Quadranten bei üblicher Bezeichnung ein Betrieb im 1. Quadranten. Das p-dotierte Bodygebiet B, das hoch n-dotierte Draingebiet D' (das ehemalige Sourcegebiet S) und das Gate G befinden sich dann auf Drainpotential UD'. In diesem Fall kann allerdings die Spannung zwischen D' und S' nicht über die Diodenflussspannung UF ansteigen. Anhand dieser Betrachtungen erkennt man, dass wegen UD'S' = UGS' der Transistor immer in der Sättigung betrieben wird und wegen UD'S' = UBS' > 0 das p-dotierte Bodygebiet gegenüber S' positiv vorgespannt ist. Eine positive Spannung am Bodygebiet reduziert aber die Schwellspannung UTH eines MOSFETs. Die durch das positive Potential am Bodygebiet verringerte Raumladung wird durch eine höhere Inversionsladung ausgeglichen.

Um eine mit einer HED vergleichbare Durchlassspannung UON zu erhalten, muss bei einem als PSD geeigneten MOSFET sowohl die Schwellspannung UTH sehr niedrig sein als auch eine nennenswerte Reduktion durch den Bodyeffekt aufweisen. Diese beiden Anforderungen widersprechen sich grundsätzlich. So ist es zur Erzielung eines großen Bodyeffekts günstig, Gateoxiddicke und Bodydotierung möglichst hoch zu wählen. Die Bodydotierung wird allerdings bereits durch die gewählte Sperrspannung bestimmt. Dies widerspricht andererseits der Forderung nach einer niedrigen Schwellspannung UTH. Aus diesem Grund muss durch eine zusätzliche Maßnahme die Schwellspannung unabhängig von Bodyeffekt eingestellt werden. Dies kann beispielsweise durch eine Thresholdimplantation mit Donatoren erfolgen. Dadurch wird die p-Dotierung an der Oberfläche des Bodygebietes abgesenkt und dadurch auch die Schwellspannung UTH. Mit diesen Maßnahmen erhält man Pseudo-Schottky-Dioden mit zu einer HED vergleichbaren Flussspannungen, die außerdem noch als Z-Dioden wirken.

In der Fig.2 ist ein Beispiel für eine Ausführung einer Pseudo-Schottky-Diode (PSD) im Querschnitt dargestellt, die das Verständnis der Erfindung erleichtert. Dabei wird ausschnittsweise nur eine Zelle betrachtet. Auf einem hoch n+-dotierten Halbleiter 1 befindet sich eine n-dotierte Schicht 2, in die p-dotierte Schichten 3 - die Bodygebiete - eingebracht sind. Innerhalb der Bodygebiete 3 befinden sich in einem gewissen Abstand - der Kanallänge L - vom Rand der Bodygebiete 3 entfernte, dünne, sehr hoch n+-dotierte Bereiche 4, die Sourcegebiete S. Auf der Halbleiteroberfläche befindet sich eine dielektrische Schicht 5 beispielsweise aus Siliziumdioxid mit einer Dicke tox im Bereich von etwa 50 - 200 nm, die die n-dotierten Gebiete 2 zwischen den Bodygebieten 3, die Bodygebiete 3 im Bereich des Kanals L und teilweise auch die Sourcegebiete 4 überlappt. Die dielektrische Schicht 5 ist mit einer hochdotierten Poly-Silizumschicht 6 - der Gateelektrode - überdeckt.

Soweit entspricht die Struktur einer üblichen planaren DMOS-Struktur.

Im Unterschied zu einer üblichen planaren DMOS-Struktur ist nun aber die Gateelektrode elektrisch nicht von den Source- und Bodygebieten 4 und 3 isoliert, sondern mit ihnen galvanisch verbunden. Oberhalb der Poly-Silizumschicht 6 und den nicht von ihr überdeckten Source- und Bodybereichen 4 und 3 befindet sich eine Metallschicht 7, die die drei Bereiche elektrisch miteinander verbindet. Das Sourcegebiet 4 ist zusätzlich auch direkt mit dem Gebiet 6 verbunden. Dies ist aber nicht zwingend erforderlich, da der Anschluss auch durch das Metall 7 erfolgt. Die Metallschicht 7 besteht vorzugsweise aus AlSiCu oder AlCu oder aus Kupfer. Oberhalb der Metallschicht 7 und unterhalb des Substrates 1 befindet sich ein Metallschichtsystem 8 und 9, das die ohmsche Kontaktierung des Substrates 1 garantiert und zudem eine lötfähige Vorderseite 8 und Rückseite 9 bildet. Das Metallschichtsystem kann beispielsweise Ti / NiV/Ag sein. Das Bauelement weist nur zwei Anschlüsse auf, den Anodenanschluss A (Gebiet 8) und den Kathodenanschluss K (Gebiet 9). Zur Reduzierung der Schwellspannung sind die p-dotierten Bodygebiete 3 einer PSD an ihrer Oberfläche - zumindest im Kanalbereich - schwächer dotiert. Dieser Bereich ist aus Gründen der Übersichtlichkeit in der Fig.2 nicht eingezeichnet.

Ein weiteres Ausführungsbeispiel für die Erfindung wird nunmehr wiederum an Hand von Fig.1 erläutert. Bezeichnungen und Funktionen stimmen mit dem vorstehend beschriebenen Ausführungsbeispiel überein. Wiederum handelt es sich bei den gleichrichtenden Elementen jeweils um einen MOSFET mit kurzgeschlossenen Gate-, Source- und Body-Gebieten, der im 3. Quadranten betrieben wird. Wiederum kann man dies als einen Betrieb in der Sättigung im 1. Quadranten bei vertauschten Source- und Drainanschlüssen S' und D' ansehen.

Im Gegensatz zum vorstehend beschriebenen Ausführungsbeispiel wird hier aber weitgehend auf den positiven Einfluss des Bodyeffekts verzichtet. Dagegen wird die Schwellspannung UTH noch wesentlich niedriger gewählt als im vorstehend beschriebenen Ausführungsbeispiel. Die niedrigen Schwellspannungen UTH werden erfindungsgemäß dadurch erreicht, dass man sehr dünne Gateoxide, die Dicken kleiner als 20 nm, beispielsweise 10 nm, haben, verwendet und zusätzlich wieder eine Thresholdimplantation des p-dotierten Bodygebiets 3 mit Donatoren durchführt. Gemäß der Erfindung besteht die dielektrische Schicht 5 aus Siliziumoxid. In anderen Ausführungsformen, die nicht Teil der Erfindung sind, können statt der üblichen SiO2-Gateoxide dielektrische Materialen mit höherer Dielektrizitätskonstante, wie beispielsweise HfO2, ZrO2, Si3N4, usw., - sogenannte high K Materialen - verwendet werden. Solche Materialien werden beispielsweise in der US 2010/0078707 beschrieben.

Falls die Spannungsbegrenzung im Loaddumpfall durch die PSDs allein nicht ausreichend ist, können im Gleichrichter auch herkömmliche Z-Dioden zu den PSDs parallel geschaltet werden. In diesem Fall muss die Durchbruchsspannung der PSD größer gewählt werden als die der Z-Dioden. Dann übernehmen die PSDs in Vorwärtsrichtung den Strom, während der Durchbruch ausschließlich in den zusätzlichen Z-Dioden stattfindet.

Des Weiteren können Strukturen in den PSDs verwendet werden, die beispielsweise zusätzlich einen weiteren pn-Übergang integriert haben, der die Durchbruchsspannung bestimmt.

Ferner können Schaltungen zum Einsatz kommen, bei denen jeweils nur die Plusdioden oder alternativ dazu nur die Minusdioden durch PSDs ersetzt sind.

## Patentansprüche

1. Generatorvorrichtung zur Spannungsversorgung eines Kraftfahrzeugs, mit mehreren Gleichrichterelementen zum Gleichrichten einer von einem Generator bereitgestellten Wechselspannung, **dadurch gekennzeichnet, dass** die Gleichrichterelemente jeweils ein hoch n-dotiertes Substrat (1), darauf eine n-dotierte Schicht (2) und in der n-dotierten Schicht (2) p-dotierte Bodygebiete (3) aufweisen, wobei sich in den Bodygebieten (3), mit einer Kanallänge L vom Rand der Bodygebiete (3) entfernt, hoch n-dotierte Sourcegebiete (4) befinden, wobei auf der Oberseite eine das Gateoxid bildende Siliziumoxidschicht (5) einen Bereich der n-dotierten Schicht (2) zwischen den Bodygebieten (3), die Bodygebiete (3) im Bereich des Kanals L und teilweise auch die Sourcegebiete (4) überdeckt, wobei die Siliziumoxidschicht (5) mit einer Gateelektrode (6) überdeckt ist, so dass die Gleichrichterelemente einen n-Kanal MOS-Feldeffekttransistor aufweisen, bei dem Gate, Bodygebiet (3) und Sourcegebiet (3) durch eine Metallschicht (7) fest elektrisch miteinander verbunden sind und bei dem das Draingebiet als Kathode dient, dass oberhalb der Metallschicht (7) und unterhalb des hoch n-dotierten Substrats ein Metallschichtsystem (8, 9) eine lötfähige Vorderseite und Rückseite bildet, dass die Gleichrichterelemente eine Durchlassspannung (UON) kleiner als 0,7 V aufweisen, wenn sie von einem Strom mit 500 A/cm² durchflossen werden, dass die Gleichrichterelemente eine Gateoxiddicke aufweisen, die kleiner ist als 20 nm und die Dotierung des Bodygebietes zumindest im Kanalbereich zur Schwellspannungsreduktion an der Oberfläche abgesenkt ist, und dass die Gleichrichterelemente jeweils in einem zweipoligen Einpressdiodengehäuse integriert sind.

2. Generatorvorrichtung nach Anspruch 1, **dadurch gekennzeichnet, dass** die Gleichrichterelemente eine integrierte Spannungsbegrenzung (Load-Dump-Schutz) aufweisen.

3. Generatorvorrichtung nach Anspruch 2, **dadurch gekennzeichnet, dass** die integrierte Spannungsbegrenzung durch den Avalanchedurchbruch der Bodydiode erfolgt.

4. Generatorvorrichtung nach einem der vorhergehenden Ansprüche, **dadurch gekennzeichnet, dass** den Gleichrichterelementen Elemente zur Spannungsbegrenzung parallel geschaltet sind.

## Claims

1. Generator device for supplying voltage to a motor vehicle, comprising a plurality of rectifier elements for rectifying an AC voltage provided by a generator, **characterized in that** the rectifier elements each have a highly n-doped substrate (1), an n-doped layer (2) thereon and p-doped body regions (3) in the n-doped layer (2), wherein highly n-doped source regions (4) are situated in the body regions (3), at a distance of a channel length L from the edge of the body regions (3), wherein on the top side a silicon oxide layer (5) forming the gate oxide covers a region of the n-doped layer (2) between the body regions (3), the body regions (3) in the region of the channel L and partly also the source regions (4), wherein the silicon oxide layer (5) is covered with a gate electrode (6), such that the rectifier elements have an n-channel MOS field effect transistor in which gate, body region (3) and source region (3) are fixedly electrically connected to one another by a metal layer (7) and in which the drain region serves as a cathode, **in that** above the metal layer (7) and below the highly n-doped substrate a metal layer system (8, 9) forms a solderable front side and rear side, **in that** the rectifier elements have a forward voltage (UON) of less than 0.7 V if a current with 500 A/cm² flows through them, **in that** the rectifier elements have a gate oxide thickness that is less than 20 nm, and the doping of the body region is reduced at least in the channel region for threshold voltage reduction at the surface, and **in that** the rectifier elements are in each case integrated in a two-pole press-fit diode housing.

2. Generator device according to Claim 1, **characterized in that** the rectifier elements have integrated voltage limiting (load dump protection).

3. Generator device according to Claim 2, **characterized in that** the integrated voltage limiting is effected by the avalanche breakdown of the body diode.

4. Generator device according to any of the preceding claims, **characterized in that** elements for voltage limiting are connected in parallel with the rectifier elements.

## Revendications

1. Dispositif générateur destiné à l'alimentation électrique d'un véhicule automobile, comprenant plusieurs éléments de redressement destinés à redresser une tension alternative fournie par un générateur, **caractérisé en ce que** les éléments de redressement possèdent respectivement un substrat fortement dopé N (1), sur celui-ci une couche dopée N (2) et, dans la couche dopée N (2), des régions de corps dopées P (3), des régions de source fortement dopées N (4) se trouvant dans les régions de corps (3), éloignées du bord des régions de corps (3) d'une longueur de canal L, une couche d'oxyde de silicium (5) formant l'oxyde de gâchette recouvrant, sur le côté supérieur, une zone de la couche dopée N (2) entre les régions de corps (3), les régions de corps (3) dans la zone du canal L et partiellement aussi les régions de source (4), la couche d'oxyde de silicium (5) étant recouverte d'une électrode de gâchette (6), de sorte que les éléments de redressement possèdent un transistor à effet de champ MOS à canal N, avec lequel la gâchette, la région de corps (3) et la région de source (3) sont reliées électriquement à demeure les unes aux autres par une couche métallique (7) et avec lequel la région de drain fait office de cathode, **en ce qu'**un système de couches métalliques (8, 9) au-dessus de la couche métallique (7) et au-dessous du substrat fortement dopé N forme un côté avant et un côté arrière aptes au brasage, **en ce que** les éléments de redressement possèdent une tension à l'état passant (UON) inférieure à 0,7 V lorsqu'ils sont traversés par un courant de 500 A/cm², **en ce que** les éléments de redressement possèdent une épaisseur d'oxyde de gâchette qui est inférieure à 20 nm et le dopage de la région de corps est abaissé au moins dans la zone du canal en vue de réduire la tension de seuil au niveau de la surface, et **en ce que** les éléments de redressement sont respectivement intégrés dans un boîtier de diode injecté bipolaire.

2. Dispositif générateur selon la revendication 1, **caractérisé en ce que** les éléments de redressement possèdent une limitation de tension (circuit de protection contre les surtensions) intégrée.

3. Dispositif générateur selon la revendication 2, **caractérisé en ce que** la limitation de tension intégrée est effectuée par un claquage par effet d'avalanche de la diode de corps.

4. Dispositif générateur selon l'une des revendications précédentes, **caractérisé en ce que** des éléments servant à la limitation de tension sont branchés en parallèle avec les éléments de redressement.
